# EUROPEAN PATENT APPLICATION

(11) **EP 1 637 625 A2**
(43) Date of publication of application: **22.03.2006**
(21) Application number: 05254682.7
(22) Date of filing: 27.07.2005
(51) Int. Cl.: C23C 14/34

(54) **Target material.**

(30) Priority: 01.09.2004 US 930794
(71) Applicant: Heraeus, Inc., Chandler, AZ 85226 (US)
(72) Inventor: Cheng, Yuanda R, Phoenix, AZ 85048 (US); Kennedy, Steven Roger, Chandler, AZ 85226 (US); Racine, Michael Gene, Phoenix, AZ 85044 (US)
(74) Representative: Hill, Justin John

(57) **Abstract**

A sputter target composed of a ferromagnetic alloy having a base metal, and X, where X is a metal having an atomic diameter of less than 0.266 nm and an oxidation potential greater than the base metal. The base metal may be Fe, Co, or any other ferromagnetic material, and may be further comprised of elements such as Pt, Ta and/or Cr to enhance its coercivity. X may be a metal selected from the group consisting of Al, Ba, Be, Ca, Cd, Ce, Cr, Cs, Dy, Er, Eu, Ga, Gd, Hf, Ho, K, La, Li, Mg, Mn, Na, Nb, Nd, Pm, Pr, Rb, Sc, Sm, Sr, Ta, Tb, Te, Th, Ti, V, Y, Zn, and Zr. The sputter target may comprise more than 0 less than 15 atomic percent X. The sputter target is reactively sputtered to form a granular medium with optimized magnetic grain size and grain-to-grain separation.

## Description

### FIELD OF THE INVENTION

The present invention relates to sputter targets and, more particularly, to improved sputter target materials which provide magnetic data-storing thin films with optimized grain size and grain-to-grain separation when reactively sputtered in the presence of oxygen.

### DESCRIPTION OF THE RELATED ART

The process of sputtering is widely used in a variety of fields to provide thin film material deposition of a precisely controlled thickness with an atomically smooth surface, for example to coat semiconductors and/or to form films on surfaces of magnetic recording media. In the reactive sputtering process, a cathodic sputter target is positioned in a vacuum chamber partially filled with a chemically reactive gas atmosphere, and is exposed to an electric field to generate a plasma. Ions within this plasma collide with a surface of the sputter target causing the sputter target to emit atoms from the sputter target surface. Material which has been sputtered off of the target chemically reacts with the reactive species in the gas mixture to form a chemical compound which forms the desired film on the surface of the substrate.

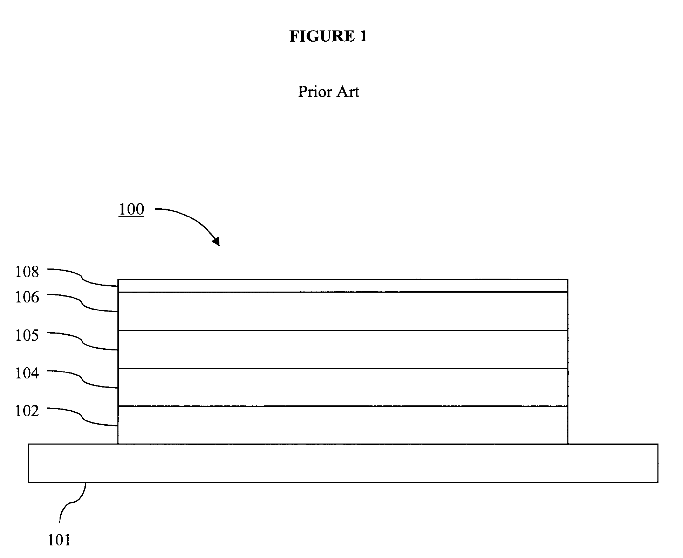

Conventional magnetic recording media typically comprise several thin film layers which are sequentially sputtered onto a substrate by multiple sputter targets. As illustrated in Figure 1, typical thin film stack 100 for conventional magnetic recording media includes non-magnetic substrate base 101, seed layer 102, at least one underlayer 104, at least one interlayer 105, at least one magnetic data-storing layer 106, and lubricant layer 108. Data is stored on magnetic data-storing layer 106 in discrete domains which are magnetized to represent on or off states of bits of data.

Grain refinement and grain-to-grain microstructural separation of magnetic materials are key in the construction of discrete magnetic domains with little cross-talk and a high signal-to-noise ratio (SNR). Various materials have been utilized as additives to cobalt (Co) based alloys, to improve this grain size reduction and separation, including chromium (Cr), boron (B) and tantalum (Ta). More recently work has begun to include dielectric materials, which effectuate the formation of "granular media," or materials with a granular microstructure in which nanoscale magnetic grains are encapsulated in an insulating matrix. Despite these enhancements, however, conventional materials have been unable to produce a data-storing thin film with sufficiently small grain size and sufficiently large grain-to-grain separation to keep up with the ever increasing demands of data storage.

As the refinement of magnetic thin film media approaches the limits of magnetic dipole stability, it is increasingly desirable to develop materials with small grain sizes and sufficient grain-to-grain separation such that each grain is not magnetically influenced by neighboring grains in the medium. In particular, it is desirable to provide a sputter target material which can be reactively sputtered to form a granular medium with optimized grain size and grain-to-grain separation.

### SUMMARY OF THE INVENTION

The present invention solves the foregoing problems by providing a sputter target material for reactively sputtering a granular medium with optimized grain size and grain-to-grain separation characteristics.

According to one aspect, the present invention is a sputter target composed of a ferromagnetic alloy having a base metal. The sputter target is further composed of X₁, a metal having an atomic diameter of less than 0.266 nm and an oxidation potential greater than that of the base metal.

The base metal of the ferromagnetic alloy of the sputter target is iron (Fe), Co, or any other ferromagnetic metal. In one arrangement, the base metal is Co, and the ferromagnetic alloy is further composed of Ta, platinum (Pt), or PtCr. In a second arrangement, the base metal is Fe, and the ferromagnetic alloys is further composed of Ta or Pt.

Considering that it is a function of the oxide material in the magnetic recording medium to act as an insulating and anti-magnetic barrier to grain-on-grain interactions, the features of the present invention include that X₁ is more quickly diffused to grain boundaries during sputtering and is more easily oxidized than other matrix materials. These features are further effectuated when X₁ has an atomic radius of less than 0.18 nm and an oxidation potential greater than -1.0 eV.

It is to be understood that the word "greater," when referring to "greater oxidation potential," indicates a more negative charge, measured in eV. For instance, an oxidation potential of -2.7 eV (Mg) is greater than that of -2.3 eV (Pm).

X₁ is selected from the list of Al, Ba, Be, Ca, Cd, Ce, Cr, Cs, Dy, Er, Eu, Ga, Gd, Hf, Ho, K, La, Li, Mg, Mn, Na, Nb, Nd, Pm, Pr, Rb, Sc, Sm, Sr, Ta, Tb, Te, Th, Ti, V, Y, Zn, and Zr. Additionally, the sputter target material is composed of more than 0 atomic percent and less than fifteen atomic percent X₁.

According to a second aspect, the present invention is a method for manufacturing a magnetic recording medium. The method includes the step of reactively sputtering in the presence of oxygen a sputter target composed of a ferromagnetic alloy having a base metal, and X₂, a metal having an atomic diameter of less than 0.266 nm and an oxidation potential greater than that of the base metal.

According to a third aspect, the present invention is a magnetic recording medium having a substrate and a data-storing thin film layer formed over the substrate. The data-storing thin film layer is composed of a ferromagnetic alloy having a base metal, and an oxide of X₃, a metal having an atomic diameter of less than 0.266 nm and an oxidation potential greater than that of the base metal.

X₃ is selected from the list of Ba, Be, Ca, Cd, Ce, Cr, Cs, Dy, Er, Eu, Ga, Gd, Hf, Ho, K, La, Li, Mg, Mn, Na, Nb, Nd, Pm, Pr, Rb, Sc, Sm, Sr, Ta, Tb, Te, Th, Ti, V, Zn, and Zr.

To its advantage, the present invention provides a granular medium with an insulating and anti-magnetic barrier to grain-on-grain interactions. If is another feature and advantage of the present invention to provide a magnetic recording medium with an improved signal-to-noise ratio.

In the following description of the preferred embodiment, reference is made to the accompanying drawings that form a part thereof, and in which is shown by way of illustration a specific embodiment in which the invention may be practiced. It is to be understood that other embodiments may be utilized and changes may be made without departing from the scope of the present invention.

### BRIEF DESCRIPTION OF THE DRAWINGS

Referring now to the drawings in which like reference numbers represent corresponding parts throughout:
Figure 1 depicts a typical thin film stack for conventional magnetic recording media;
Figure 2 depicts a sputter target according to one embodiment of the present invention;
Figures 3A, 3B and 3C depict both macroscopic and microscopic views of the reactive sputtering of a sputter target to form a magnetic recording medium according to one embodiment of the present invention;
Figure 4 is a flowchart depicting the process of reactively sputtering a sputter target according to one embodiment of the present invention; and
Figure 5 depicts a thin film stack with an enhanced magnetic data-storing layer according to one embodiment of the present invention.

### DETAILED DESCRIPTION OF THE INVENTION

The present invention is an enhanced sputter target material which can be reactively sputtered to form magnetic data-storing thin films having granular media with optimized grain size and improved grain-to-grain separation.

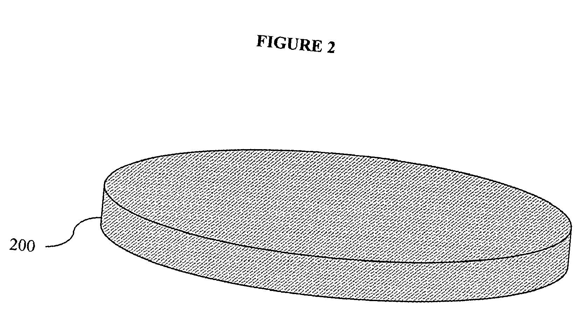

Figure 2 depicts a sputter target according to one embodiment of the present invention. Sputter target 200 is composed of a ferromagnetic alloy having a base metal, and X₁, a metal having an atomic diameter of less than 0.266 nm and an oxidation potential greater than that of the base metal.

The base metal of the ferromagnetic alloy of the sputter target is Fe, Co, or any other ferromagnetic metal. In one arrangement, the base metal is Co, and the ferromagnetic alloy is further composed of Ta, Pt, or PtCr. In a second arrangement, the base metal is Fe, and the ferromagnetic alloys is further composed of Ta or Pt.

It is a function of the oxide material in the magnetic recording medium to act as an insulating and anti-magnetic barrier to grain-on-grain interactions. As such, the features of the present invention include that X₁ is more quickly diffused to grain boundaries during sputtering and is more easily oxidized than other matrix materials. In this regard, the metals of Table 1 are to be considered as primary candidates for oxides in effective granular magnetic media. These features are further effectuated when X₁ is selected from the metals of Table 1 combining the greatest oxidation potential (< -1.0 eV) and lowest atomic diameter (< 0.18 nm).

**TABLE 1**

| Metals sorted by Greatest Oxidation Potential | | | |
|---|---|---|---|
| Element | Oxidation Potential* | Atomic Radius^{†} | Ionic Radius^{†} |
| Li | -3.0401 | 1.52 | 0.76 |
| Cs | -3.026 | 2.65 | 1.67 |
| Rb | -2.98 | 2.48 | 1.52 |
| K | -2.931 | 2.31 | 1.38 |
| Ba | -2.912 | 2.22 | 1.35 |
| Sr | -2.899 | 2.15 | 1.18 |
| Ca | -2.868 | 1.98 | 1.00 |
| Na | -2.71 | 1.86 | 1.02 |
| Mg | -2.7 | 1.61 | 0.72 |
| La | -2.379 | 1.88 | 1.03 |
| Y | -2.372 | 1.80 | 0.90 |
| Pr | -2.353 | 1.83 | 0.99 |
| Ce | -2.336 | 1.72 | 1.02 |
| Er | -2.331 | 1.76 | 0.89 |
| Ho | -2.33 | 1.77 | 0.90 |
| Nd | -2.323 | 1.82 | 0.98 |
| Sm | -2.304 | 1.80 | 0.96 |
| Pm | -2.3 | 1.81 | 0.97 |
| Dy | -2.295 | 1.77 | 0.91 |
| Tb | -2.28 | 1.78 | 0.92 |
| Gd | -2.279 | 1.80 | 0.94 |
| Sc | -2.077 | 1.64 | 0.75 |
| Eu | -1.991 | 2.04 | 0.95 |
| Th | -1.899 | 1.79 | 0.94 |
| Be | -1.847 | 1.14 | 0.27 |
| Al | -1.662 | 1.43 | 0.54 |
| Ti | -1.63 | 1.46 | 0.61 |
| Hf | -1.55 | 1.59 | 0.71 |
| Zr | -1.45 | 1.60 | 0.72 |
| Mn | -1.185 | 1.12 | 0.67 |
| V | -1.175 | 1.34 | 0.54 |
| Te | -1.143 | 1.60 | 0.56-0.97 |
| Nb | -1.099 | 1.46 | 0.64 |
| Zn | -0.7618 | 1.39 | 0.74 |
| Cr | -0.744 | 1.25 | 0.55 |
| Ta | -0.6 | 1.46 | 0.64 |
| Ga | -0.539 | 1.35 | 0.62 |
| Cd | -0.403 | 1.51 | 0.95 |

| | | | |
|---|---|---|---|
| * in eV | | | |
| † in Ångstroms | | | |

Additionally, the sputter target material is composed of more than 0 atomic percent and less than fifteen atomic percent X₁.

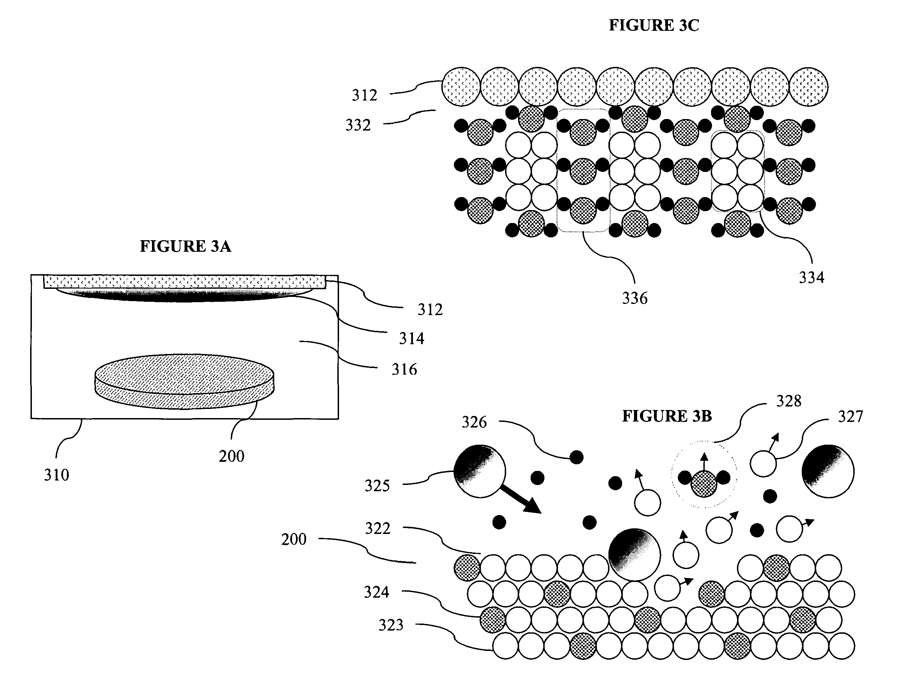

Figures 3A, 3B and 3C depict the reactive sputtering of a sputter target to form a magnetic recording medium according to one embodiment of the present invention.

In more detail, Figure 3A depicts a macroscopic view of sputtering chamber 310. In the sputtering process, sputter target 200 is positioned in sputtering chamber 310, which is partially filled with both an inert gas and oxygen. Sputter target 200 is exposed to an electric field to excite the gas species to generate plasma 316. Ions within plasma 316 collide with a surface of sputter target 200 causing molecules to be emitted from the surface of sputter target 200. Some of the material which has been ejected off of sputter target 200 chemically reacts with oxygen in plasma 316 to form oxide molecules. A difference in voltage between sputter target 200 and substrate 312 causes the emitted molecules to form the desired thin film 314 on the surface of substrate 312.

Figure 3B depicts a microscopic view of sputter target 200 during the above-described sputtering process. At the molecular level, sputter target 200 is seen to be composed of molecules of ferromagnetic alloy 323 and X₂ molecules 324, where X₂ is a metal having an atomic diameter of less than 0.266 nm and an oxidation potential greater than that of the base metal. Surface 322 of sputter target 200 is bombarded by energetic ions 325 of the sputtering gas species of the plasma, such that molecules from sputter target 200 are ejected from surface 322. X₂ molecules 324 which are ejected react with oxygen molecules 326 in the plasma to form oxide groups 328, which, together with ejected ferromagnetic alloy molecules 327, are not in a state of thermodynamic equilibrium. Accordingly, these molecules will tend to condense back into the solid phase upon colliding with any surface in the sputtering chamber.

Figure 3C depicts a microscopic view of substrate 312. Surface 332 of substrate 312 is coated with the ejected molecules from sputter target 200, which have condensed to form discrete grains 334 of ferromagnetic material and matrix 336 of oxide groups. Matrix 336 of oxide groups acts as an insulating and anti-magnetic barrier to interactions between grains 334 of ferromagnetic material, thereby improving the signal-to-noise ratio of the magnetic recording medium.

It is to be understood that Figures 3A, 3B, and 3C are not drawn to scale, and are merely simplified representations of the features of the present invention.

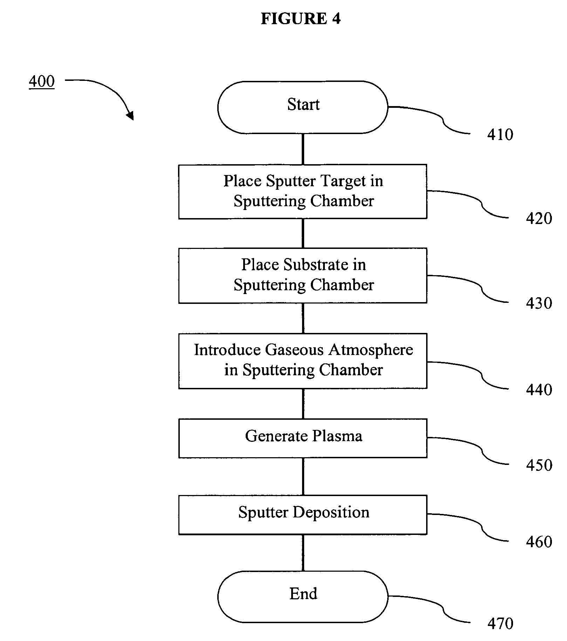

In Figure 4, flowchart 400 illustrates the steps of reactively sputtering a sputter target to deposit a thin film granular medium according to one embodiment of the present invention.

In step 410, the process begins. In step 420, a sputter target is provided, and is disposed inside of a sputtering chamber. The sputter target is composed of a ferromagnetic alloy having a base metal. The sputter target is further composed of X₂, a metal having an atomic diameter of less than 0.266 nm and an oxidation potential greater than that of the base metal. The sputtering chamber is a vacuum chamber in which a reactive plasma can be contained, and in which both sputter targets and substrates can be disposed.

In step 430, a substrate is provided, and is disposed inside of the sputtering chamber. The substrate is positioned so as to accumulate a thin film during the sputtering process. In step 440, the gaseous atmosphere, comprising both a non-reactive gas species and oxygen, is introduced into the sputtering chamber to form a partial vacuum.

In step 450, the gas species in the sputtering chamber are excited to create a plasma. The gas species are excited by applying a voltage difference between the substrate and the sputter target. In step 460, the material of the sputter target is deposited as a granular medium onto the substrate. This deposition is the result of the sputter target being bombarded by energetic ions of the sputtering gas species in the plasma, such that molecules from the sputter target are ejected from its surface. Molecules of X₂ which are ejected react with the oxygen molecules in the plasma to form oxide groups. Both these oxide groups and the ejected molecules of the ferromagnetic alloy, are not in a state of thermodynamic equilibrium, and will therefore tend to condense back into their solid phase upon colliding with any surface in the sputtering chamber. The substrate, being such a surface, therefore accumulates a thin film of the desired material during the sputtering process. In step 470, the process terminates.

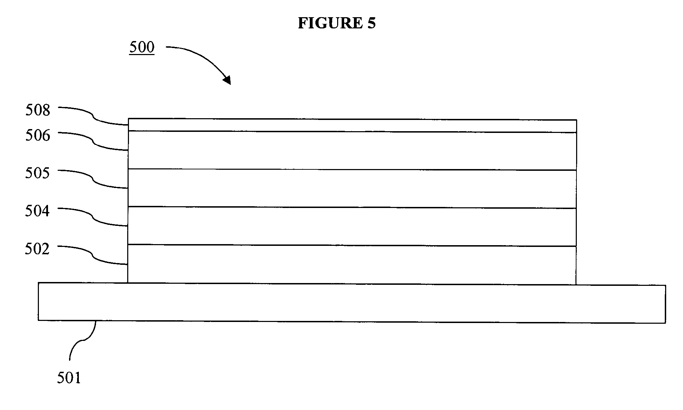

Figure 5 depicts a thin film stack in which the magnetic data-storing layer has been reactively sputtered in the presence of oxygen by a sputter target composed of an enhanced composition according to one embodiment of the present invention.

In more detail, magnetic recording medium 500 includes non-magnetic substrate base 501, seed layer 502, at least one underlayer 504, at least one interlayer 505, data-storing thin film layer 506, and lubricant layer 508. The data-storing thin film layer 506 on magnetic recording medium 500 is composed of a ferromagnetic alloy, the ferromagnetic alloy having a base metal, and an oxide of X₃, where X₃ is a metal having an atomic diameter of less than 0.266 nm and an oxidation potential greater than that of the base metal. In an alternate arrangement, magnetic recording medium 500 omits seed layer 502, underlayer 504, interlayer 505 and/or lubricant layer 508.

Considering that it is a function of the oxide material in the magnetic recording medium to act as an insulating and anti-magnetic barrier to grain-on-grain interactions, features of the present invention include that X₃ is more quickly diffused to grain boundaries during sputtering and is more easily oxidized than other matrix materials. In this regard, the metals of Table 2 are to be considered as primary candidates for oxides in effective granular magnetic media. These features are further effectuated when X₃ is selected from the metals combining the lowest atomic diameter (< 0.18 nm) and greatest oxidation potential (< -1.0 eV).

**TABLE2**

| Metals sorted by Lowest Atomic Radius | | | |
|---|---|---|---|
| Element | Oxidation Potential^{*} | Atomic Radius^{†} | Ionic Radius^{†} |
| Mn | -1.185 | 1.12 | 0.67 |
| Be | -1.847 | 1.14 | 0.27 |
| Cr | -0.744 | 1.25 | 0.55 |
| V | -1.175 | 1.34 | 0.54 |
| Ga | -0.539 | 1.35 | 0.62 |
| Zn | -0.7618 | 1.39 | 0.74 |
| Ti | -1.63 | 1.46 | 0.61 |
| Nb | -1.099 | 1.46 | 0.64 |
| Ta | -0.6 | 1.46 | 0.64 |
| Cd | -0.403 | 1.51 | 0.95 |
| Li | -3.0401 | 1.52 | 0.76 |
| Hf | -1.55 | 1.59 | 0.71 |
| Zr | -1.45 | 1.60 | 0.72 |
| Te | -1.143 | 1.60 | 0.56-0.97 |
| Mg | -2.7 | 1.61 | 0.72 |
| Sc | -2.077 | 1.64 | 0.75 |
| Ce | -2.336 | 1.72 | 1.02 |
| Er | -2.331 | 1.76 | 0.89 |
| Ho | -2.33 | 1.77 | 0.90 |
| Dy | -2.295 | 1.77 | 0.91 |
| Tb | -2.28 | 1.78 | 0.92 |
| Th | -1.899 | 1.79 | 0.94 |
| Sm | -2.304 | 1.80 | 0.96 |
| Gd | -2.279 | 1.80 | 0.94 |
| Pm | -2.3 | 1.81 | 0.97 |
| Nd | -2.323 | 1.82 | 0.98 |
| Pr | -2.353 | 1.83 | 0.99 |
| Na | -2.71 | 1.86 | 1.02 |
| La | -2.379 | 1.88 | 1.03 |
| Ca | -2.868 | 1.98 | 1.00 |
| Eu | -1.991 | 2.04 | 0.95 |
| Sr | -2.899 | 2.15 | 1.18 |
| Ba | -2.912 | 2.22 | 1.35 |
| K | -2.931 | 2.31 | 1.38 |
| Rb | -2.98 | 2.48 | 1.52 |
| Cs | -3.026 | 2.65 | 1.67 |

| | | | |
|---|---|---|---|
| * in eV | | | |
| † in Angstroms | | | |

Additionally, the magnetic recording medium is composed of more than 0 atomic percent and less than fifteen atomic percent X₃.

The invention has been described with particular illustrative embodiments. It is to be understood that the invention is not limited to the above-described embodiments and that various changes and modifications may be made by those of ordinary skill in the art without departing from the spirit and scope of the invention.

## Claims

1. A sputter target comprised of:
a ferromagnetic alloy, the ferromagnetic alloy comprising a base metal; and
X₁, wherein X₁ is a metal having an atomic diameter of less than 0.266 nm and an oxidation potential greater than that of the base metal.

2. A sputter target according to Claim 1, wherein said base metal is Co.

3. A sputter target according to Claim 2, wherein said ferromagnetic alloy further comprises Ta.

4. A sputter target according to Claim 2, wherein said ferromagnetic alloy further comprises Pt.

5. A sputter target according to Claim 4, wherein said ferromagnetic alloy further comprises Cr.

6. A sputter target according to Claim 1, wherein said base metal is Fe.

7. A sputter target according to Claim 6, wherein said ferromagnetic alloy further comprises Ta.

8. A sputter target according to Claim 6, wherein said ferromagnetic alloy further comprises Pt.

9. A sputter target according to Claim 1, wherein X₁ is a metal selected from the group consisting of Al, Ba, Be, Ca, Cd, Ce, Cr, Cs, Dy, Er, Eu, Ga, Gd, Hf, Ho, K, La, Li, Mg, Mn, Na, Nb, Nd, Pm, Pr, Rb, Sc, Sm, Sr, Ta, Tb, Te, Th, Ti, V, Y, Zn, and Zr.

10. A sputter target according to Claim 1, wherein X₁ has an atomic radius of less than 0.18 nm.

11. A sputter target according to Claim 1, wherein the sputter target comprises more than 0 atomic percent and less than 15 atomic percent X₁.

12. A method for manufacturing a magnetic recording medium, comprising the step of:
reactively sputtering a sputter target in an atmosphere comprising oxygen, wherein the sputter target is comprised of
a ferromagnetic alloy, the ferromagnetic alloy comprising a base metal; and
X₂, wherein X₂ is a metal having an atomic diameter of less than 0.266 nm and an oxidation potential greater than that of the base metal.

13. A magnetic recording medium sputtered on a substrate, comprising:
a data-storing thin film layer formed over the substrate, wherein said data-storing thin film layer is comprised of:
a ferromagnetic alloy, the ferromagnetic alloy comprising a base metal; and
an oxide of X₃, wherein X₃ is a metal having an atomic diameter of less than 0.266 nm and an oxidation potential greater than that of the base metal.

14. A medium according to Claim 13, wherein said base metal is Co.

15. A medium according to Claim 14, wherein said ferromagnetic alloy further comprises Ta.

16. A medium according to Claim 14, wherein said ferromagnetic alloy further comprises Pt.

17. A medium according to Claim 16, wherein said ferromagnetic alloy further comprises Cr.

18. A medium according to Claim 13, wherein said base metal is Fe.

19. A medium according to Claim 18, wherein said ferromagnetic alloy further comprises Pt.

20. A medium according to Claim 18, wherein said ferromagnetic alloy further comprises Ta.

21. A medium according to Claim 13, wherein X₃ is selected from the group consisting of Ba, Be, Ca, Cd, Ce, Cr, Cs, Dy, Er, Eu, Ga, Gd, Hf, Ho, K, La, Li, Mg, Mn, Na, Nb, Nd, Pm, Pr, Rb, Sc, Sm, Sr, Ta, Tb, Te, Th, Ti, V, Zn, and Zr.

22. A medium according to Claim 13, wherein X₃ has an atomic radius of less than 0.18 nm.

23. A medium according to Claim 13, wherein the medium comprises more than 0 atomic percent and less than 15 atomic percent X₃
